# EUROPEAN PATENT APPLICATION

(11) **EP 4 459 305 A1**
(43) Date of publication of application: **06.11.2024**
(21) Application number: 24173508.3
(22) Date of filing: 30.04.2024
(51) Int. Cl.: G01R 31/42

(54) **TESTING APPARATUS FOR POWER DISTRIBUTION UNITS OF COMPUTER EQUIPMENT CABINETS**

(30) Priority: 01.05.2023 US 202363499488 P
(71) Applicant: Vertiv Corporation, Westerville, OH 43082 (US)
(72) Inventor: Harmelin, Nicholas J., Delaware, 43015 (US); Snavely, Kirk A., Tennessee, 37055 (US)
(74) Representative: Bryn-Jacobsen, Caelia

(57) **Abstract**

A junction box for facilitating testing of a rack power distribution unit with a load bank can include a terminal block electrically coupled to the load bank by high amperage cables as well as multiple line receptacles and multiple neutral receptacles. The receptacles can be electrically coupled to the terminal block by lower amperage wires. The receptacles can be electrically coupled to the terminal block through switches and/or fuses. The junction box can include visual indicators to warn of voltage differential between respective pairs of receptacles.

## Description

### CROSS REFERENCE TO RELATED APPLICATIONS

This application claims the benefit of U.S. Provisional Patent Application No. 63/499,488 filed May 1, 2023.

### STATEMENT REGARDING FEDERALLY SPONSORED RESEARCH OR DEVELOPMENT

Not applicable.

### REFERENCE TO APPENDIX

Not applicable.

### BACKGROUND OF THE INVENTION

Field of the Invention. The present disclosure relates generally to computer equipment cabinets and more specifically relates to testing of equipment for computer equipment cabinets.

Description of the Related Art. Computer equipment racks or cabinets, such as those used in computer datacenters, often have power distribution units and/or other equipment mounted thereto, such as power generation, power conditioning or thermal conditioning units. On occasion, such equipment needs to be tested. Current methods and systems tend to be time consuming and subject to human error. For example, technicians currently may be required to connect a variety of wires between these rack mounted power distribution units and load banks. This wiring can be labor intensive and subject to human error in miswiring, which can cause additional problems, including injury.

### BRIEF SUMMARY OF THE INVENTION

Applicants have created new and useful devices, systems and methods for testing power distribution units and/or other equipment for computer equipment cabinets.

In at least one example, a computer datacenter can include a computer equipment cabinet or rack, at least one rack power distribution unit mounted to the rack, a load bank mounted to the rack for testing the rack power distribution unit, a junction box electrically coupled to the load bank for facilitating testing power outlets of the rack power distribution unit, or any combination thereof. In at least one example, the rack power distribution unit can have one or more power outlets. In at least one example, each outlet can be rated at a first amperage and the load bank can be rated at a second amperage, and the second amperage can be greater than the first amperage.

In at least one example, the junction box can include a terminal block electrically coupled to the load bank by a line cable and/or a neutral cable, first and second line receptacles, first and second neutral receptacles, or any combination thereof. In at least one example, the line cable and/or the neutral cable can be rated for the second, higher amperage. In at least one example, the terminal block can be mounted within the junction box and/or each receptacle can be mounted through a hinged door of the junction box.

In at least one example, the first and second line receptacles can be electrically coupled to the terminal block through a first and second line wire, respectively. In at least one example, the first and second neutral receptacles can be electrically coupled to the terminal block through a first and second neutral wire, respectively. In at least one example, line wires and/or the neutral wires can be rated for the first, lower amperage. In at least one example, each line receptacle and/or each neutral receptacle also can be electrically coupled to the terminal block through an individual switch and/or an individual fuse rated for the first amperage but not the second amperage.

In at least one example, the cabinet can include a test cable configured to selectively electrically couple one of the outlets of the rack power distribution unit to one of the line receptacles and one of the neutral receptacles. In at least one example, the cabinet can include a test cable for each outlet and/or set of line and neutral receptacles.

In at least one example, the junction box can include a first visual indicator electrically coupled between the line receptacles and/or a second visual indicator electrically coupled between the neutral receptacles. In at least one example, the first visual indicator can be configured to indicate a voltage differential between the line receptacles. In at least one example, the second visual indicator can be configured to indicate a voltage differential between the neutral receptacles. In at least one example, the junction box can include visual indicators electrically coupled between each pair of line receptacles and/or each pair of neutral receptacles.

In at least one example, the junction box can include two or more ground receptacles. In at least one example, each ground receptacle can be electrically coupled to the terminal block through a ground wire. In at least one example, the ground wires can be rated for the first, lower amperage. In at least one example, the terminal block can be electrically coupled to the load bank by a ground cable. In at least one example, the ground cable can be rated for the second, higher amperage.

In at least one example, the junction box can include four line receptacles and four neutral receptacles. In at least one example, the first amperage can be one-quarter of the second amperage. For example, the wires can be rated for 15 amps or less and the cables can be rated for 40 amps or greater, such as 60 amps.

In at least one example, the line cable, the first line wire, and the second line wire can be electrically coupled to one terminal of the terminal block. In at least one example, the neutral cable, the first neutral wire, and the second neutral wire can be electrically coupled to another, different terminal of the terminal block.

In at least one example, a junction box for facilitating testing of a rack power distribution unit with a load bank can include a terminal block electrically coupled to the load bank by a line cable and a neutral cable, a first and a second line receptacle, a first and a second neutral receptacle, a first and a second test cable, or any combination thereof. In at least one example, the line cable and/or the neutral cable can be rated for a first amperage. In at least one example, the first and/or the second line receptacle can be electrically coupled to the terminal block through a first and/or a second line wire. In at least one example, the first and/or the second neutral receptacle can be electrically coupled to the terminal block through a first and/or a second neutral wire. In at least one example, the line wire(s) and/or the neutral wire(s) can be rated for a second amperage, with the second amperage being less than the first amperage. In at least one example, each test cable can be configured to selectively electrically couple an outlet of the rack power distribution unit to one of the line receptacles and one of the neutral receptacles. In at least one example, the terminal block can be mounted within the junction box and each receptacle can be mounted through a hinged door of the junction box.

In at least one example, each line receptacle and/or each neutral receptacle are also electrically coupled to the terminal block through an individual switch and/or individual fuse rated for the second, lower amperage but not the first, higher amperage. In at least one example, the line cable, the first line wire, and the second line wire can be electrically coupled to a first terminal of the terminal block. In at least one example, the neutral cable, the first neutral wire, and the second neutral wire can be electrically coupled to a second, different terminal of the terminal block.

In at least one example, the junction box can include a first visual indicator electrically coupled between the line receptacles and a second visual indicator electrically coupled between the neutral receptacles. In at least one example, the first visual indicator can be configured to indicate a voltage differential between the line receptacles. In at least one example, the second visual indicator can be configured to indicate a voltage differential between the neutral receptacles.

In at least one example, the junction box can include first and second ground receptacles. In at least one example, each ground receptacle can be electrically coupled to the terminal block through a ground wire. In at least one example, the ground wire can be rated for the second, lower amperage. In at least one example, the terminal block can be electrically coupled to the load bank by a ground cable, the ground cable being rated for the first, higher amperage. In at least one example, the junction box includes four line receptacles, four neutral receptacles, four ground receptacles. In at least one example, the first amperage can be four times the second amperage.

In at least one example, a junction box for facilitating testing of a rack power distribution unit with a load bank can include a terminal block electrically coupled to the load bank, four line receptacles, four neutral receptacles, four ground receptacles, four test cables, or any combination thereof. In at least one example, the terminal block can be electrically coupled to the load bank by a line cable and a neutral cable, with each cable being rated for a first amperage, such as 60 amps. In at least one example, each line receptacle can be electrically coupled to the terminal block through an individual line wire, an individual fuse, and an individual switch, with the line wires and the fuses being rated for a second, lower amperage, such as 15 amps. In at least one example, each neutral receptacle can be electrically coupled to the terminal block through an individual neutral wire, an individual fuse, and an individual switch, with the neutral wires and the fuses being rated for the second, lower amperage, such as 15 amps. In at least one example, each ground receptacle can be electrically coupled to the terminal block through an individual ground wire, with the ground wires being rated for the second, lower amperage, such as 15 amps. In at least one example, each test cable can be configured to selectively electrically couple an outlet of the rack power distribution unit to one of the line receptacles, one of the neutral receptacles, and one of the ground receptacles. In at least one example, the terminal block and/or the fuses can be mounted within the junction box. In at least one example, each receptacle and/or each switch can be mounted through a hinged door of the junction box.

In at least one example, the junction box can include four line visual indicators. In at least one example, each line visual indicator can be electrically coupled between two different ones of the line receptacles. In at least one example, each line visual indicator can be configured to indicate a voltage differential between the respective line receptacles.

In at least one example, the junction box can include four line neutral indicators. In at least one example, each neutral visual indicator can be electrically coupled between two different ones of the neutral receptacles. In at least one example, each neutral visual indicator can be configured to indicate a voltage differential between the respective neutral receptacles.

In at least one example, the line cable and the line wires can be electrically coupled to a first terminal of the terminal block. In at least one example, the neutral cable and the neutral wires can be electrically coupled to another terminal of the terminal block. In at least one example, the ground cable and the ground wires can be electrically coupled to still another terminal of the terminal block.

### BRIEF DESCRIPTION OF THE SEVERAL VIEWS OF THE DRAWINGS

FIG. 1 is a perspective view of one of many examples of a computer datacenter according to the disclosure.
FIG. 2 is a block diagram of one of many examples of a computer equipment cabinet according to the disclosure.
FIG. 3 is a schematic drawing of one of many examples of a junction box according to the disclosure.
FIG. 4 is a perspective view of one of many examples of a junction box according to the disclosure.
FIG. 5 is an elevation view of one of many examples of a junction box according to the disclosure.
FIG. 6 is a perspective view of one of many examples of a test cable according to the disclosure.
FIG. 7 is a perspective view of one of many examples of a power distribution unit coupled to a computer equipment cabinet according to the disclosure.
FIG. 8 is a front elevation view of one of many examples of a computer equipment cabinet according to the disclosure.
FIG. 9 is a rear perspective view of one of many examples of a computer equipment cabinet having a power distribution unit coupled thereto according to the disclosure.
FIG. 10 is a block diagram of one of many examples of a testing assembly according to the disclosure.

### DETAILED DESCRIPTION OF THE INVENTION

The Figures described above and the written description of specific structures and functions below are not presented to limit the scope of what Applicants have invented or the scope of the appended claims. Rather, the Figures and written description are provided to teach any person skilled in the art to make and use the inventions for which patent protection is sought. Those skilled in the art will appreciate that not all features of a commercial example of the inventions are described or shown for the sake of clarity and understanding. Persons of skill in this art will also appreciate that the development of an actual commercial example incorporating aspects of the present inventions will require numerous implementation-specific decisions to achieve the developer's ultimate goal for the commercial example. Such implementation-specific decisions can include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the Figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts or block diagrams discussed herein illustrate the operation of possible implementations of systems, methods, and/or computer program products according to various examples of the disclosure. In this regard, each block in a flowchart or diagram may represent a module, segment, or portion of code, which can include one or more executable instructions for implementing the specified logical function(s). It should also be noted that, in some implementations, the functions noted in the block(s) might occur out of the order depicted in the figures. For example, blocks shown in succession may, in fact, be executed substantially concurrently. It will also be noted that, where applicable, each block of a flowchart illustration or diagram can be implemented by special purpose hardware-based systems that perform the specified functions or acts, or combinations of special purpose hardware and computer instructions.

Applicants have created new and useful devices, systems and methods for testing rack power distribution units 100 for computer datacenters 200, such as, for example, Vertiv^{™} SmartMod^{™} modular datacenters. In at least one example, a computer datacenter 200 can enclose or otherwise include one or more computer equipment cabinets or racks 220 and one or more power distribution units (or PDUs), such as one or more rack power distribution units (or rPDUs), for distributing power to equipment housed within or otherwise associated with the one or more cabinets or racks 220. Implementations of the present disclosure advantageously provide for convenient, efficient and safe testing of PDUs and/or other equipment for computer equipment cabinets and datacenters, such as power generation units, power conditioning units and thermal conditioning units.

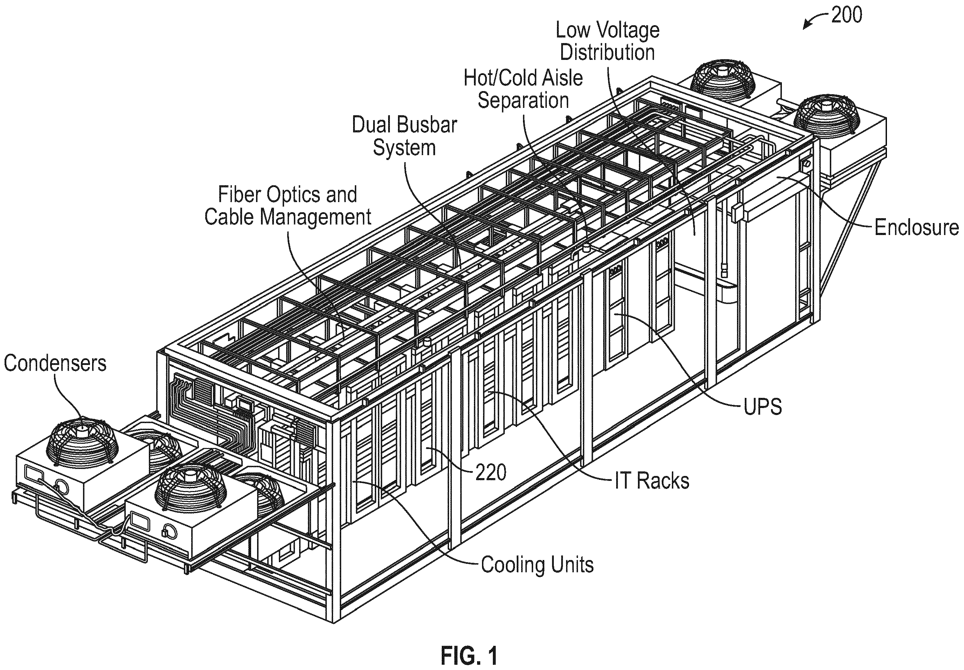

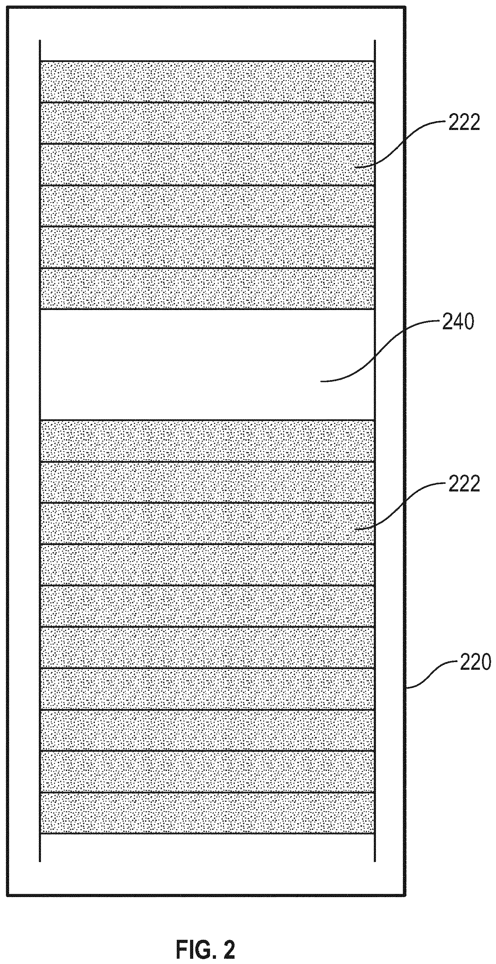

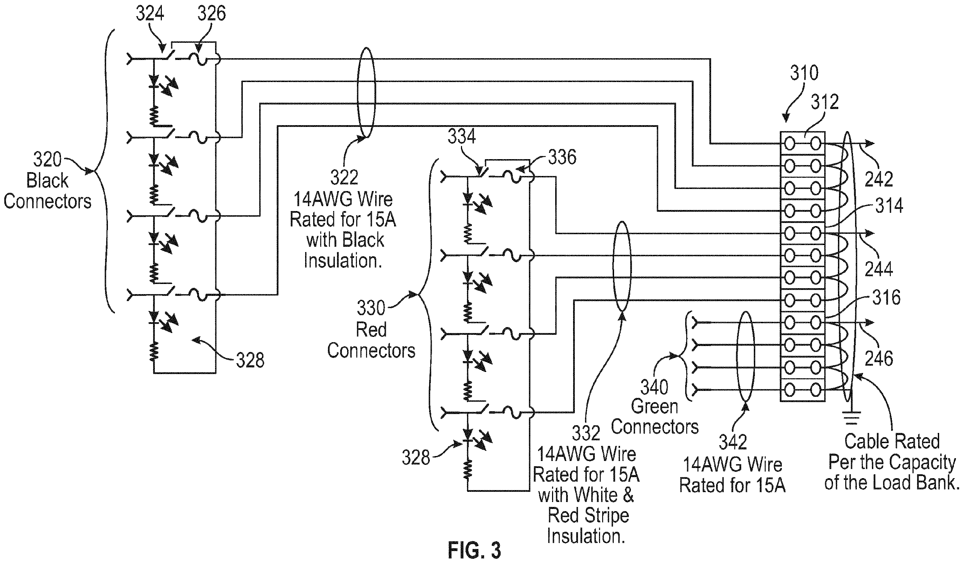

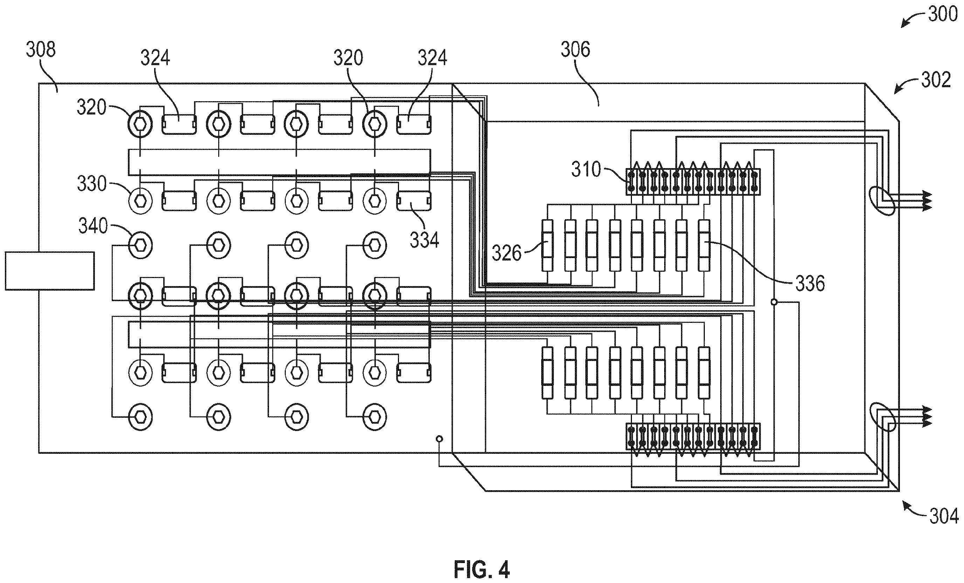

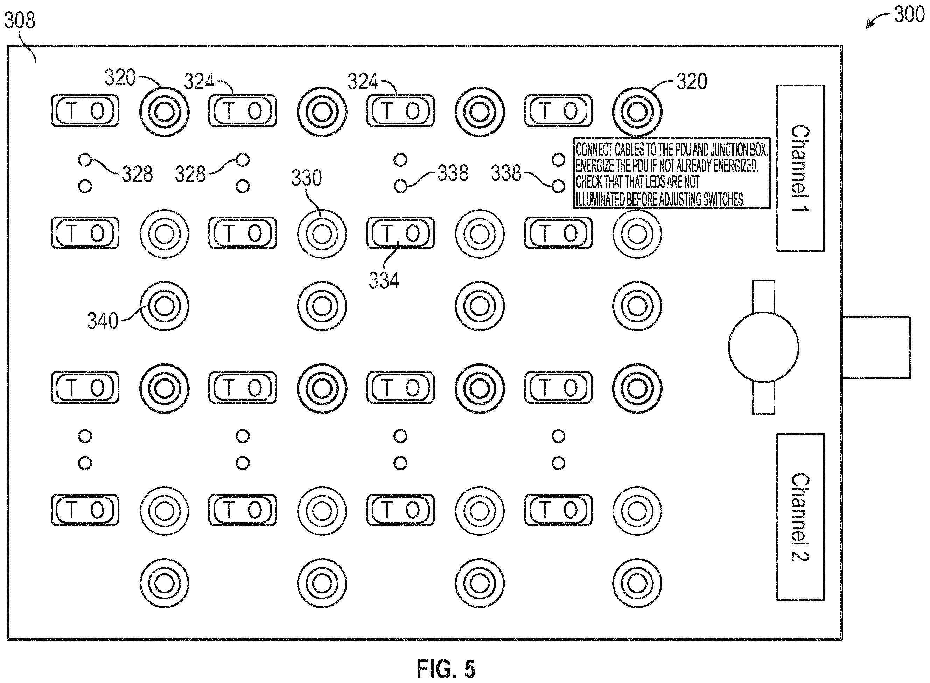

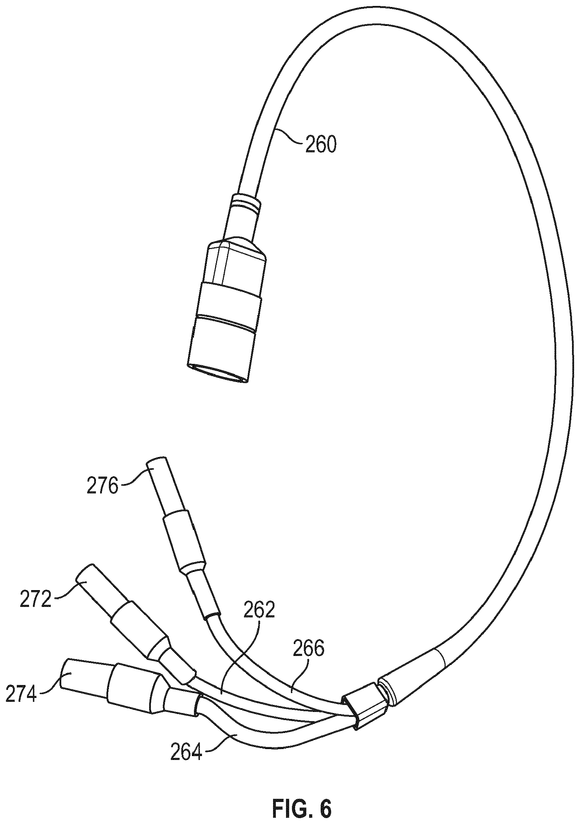

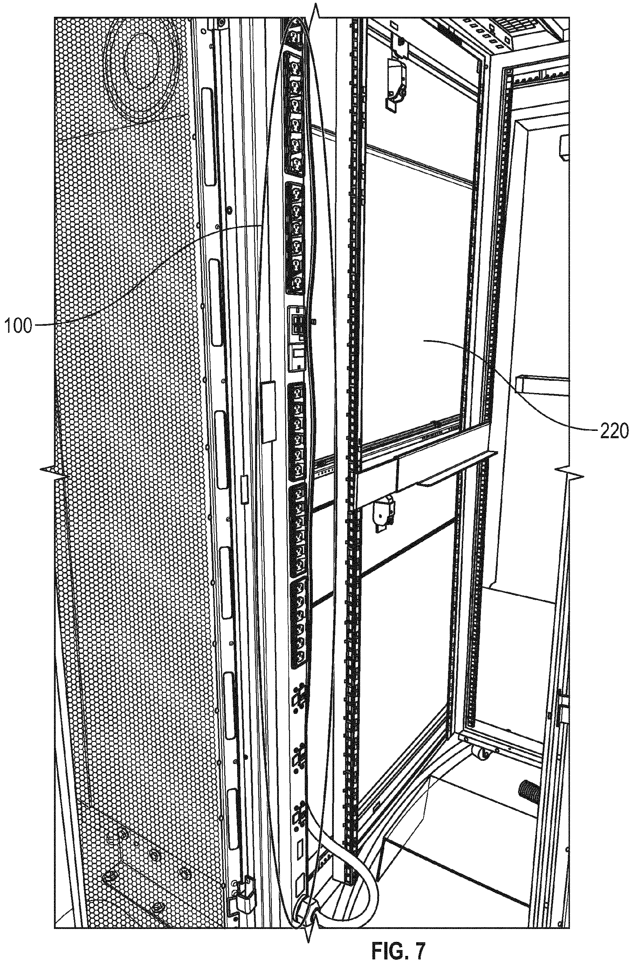

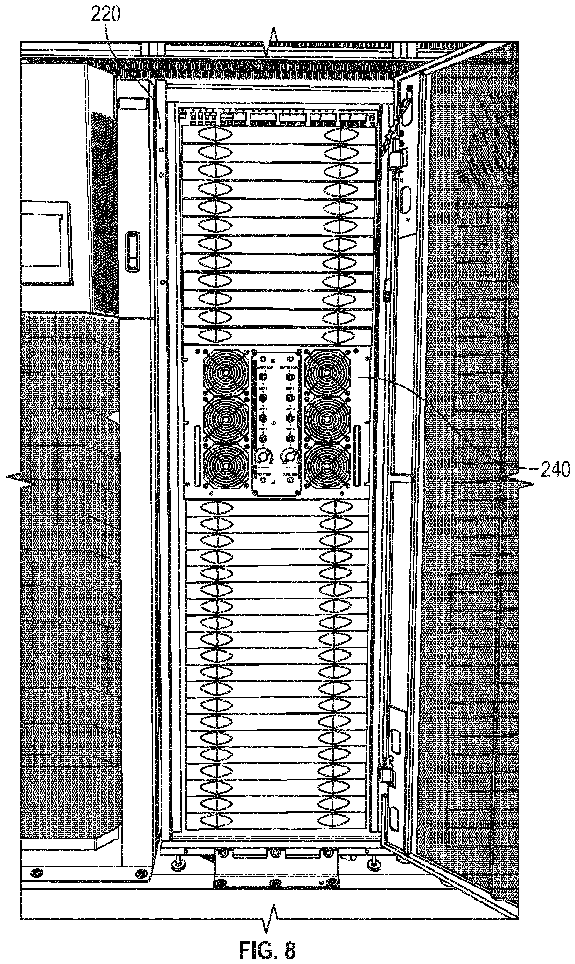

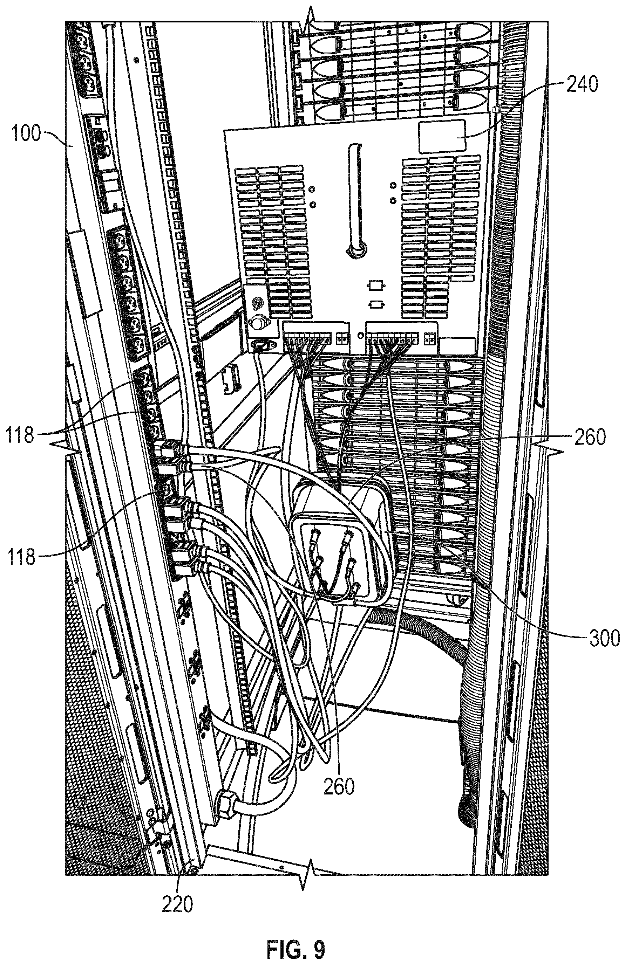

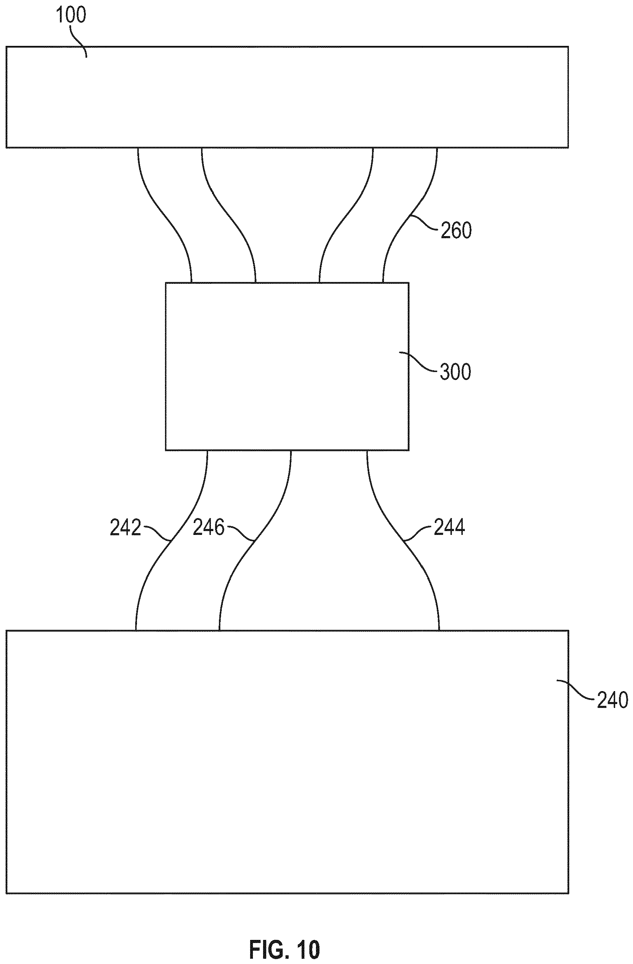

FIG. 1 is a perspective view of one of many examples of a computer datacenter according to the disclosure. FIG. 2 is a block diagram of one of many examples of a computer equipment cabinet according to the disclosure. FIG. 3 is a schematic drawing of one of many examples of a junction box according to the disclosure. FIG. 4 is a perspective view of one of many examples of a junction box according to the disclosure. FIG. 5 is an elevation view of one of many examples of a junction box according to the disclosure. FIG. 6 is a perspective view of one of many examples of a test cable according to the disclosure. FIG. 7 is a perspective view of one of many examples of a power distribution unit coupled to a computer equipment cabinet according to the disclosure. FIG. 8 is a front elevation view of one of many examples of a computer equipment cabinet according to the disclosure. FIG. 9 is a rear perspective view of one of many examples of a computer equipment cabinet having a power distribution unit coupled thereto according to the disclosure. FIG. 10 is a block diagram of one of many examples of a testing assembly according to the disclosure. FIGS. 1-10 are described in conjunction with one another.

In at least one example, a computer datacenter 200 can include a computer equipment cabinet or rack 220 for housing or otherwise supporting one or more computing devices 222, at least one rack power distribution unit 100 mounted to the rack 220, a load bank 240 mounted to the rack 220 for testing one or more electrical aspects of associated equipment, a junction box 300 electrically coupled to the load bank 240 for facilitating testing power outlets 118 of the rack power distribution unit 100, or any combination thereof. In at least one example, computing devices 222 can be or include any of various computing and/or support devices, such as servers, routers, switches, uninterruptible power supplies, cooling units, blanking panels, or any combination thereof.

In at least one example, the rack power distribution unit 100 can have one or more power outlets 118. In at least one example, each outlet 118 can be rated at a first amperage, such as 10 or 15 amps. In at least one example, the load bank can be rated at a second, higher amperage, such as 40 or 60 amps.

In at least one example, the junction box 300 can include one or more channels. In at least one example, the junction box 300 can include a first channel 302 and a second channel 304. In at least one example, the junction box 300 can include a main body 306 providing a cavity for containing components of the junction box 300. In at least one example, the junction box 300 can include a door 308 hingedly mounted to the body 306. In at least one example, the door 308 can include a latch to sealingly secure the door 308 to the body 306.

In at least one example, the junction box 300, or each channel thereof, can include a terminal block 310 electrically coupled to the load bank 240 by a line cable 242 and/or a neutral cable 244, first and second line receptacles 320, first and second neutral receptacles 330, or any combination thereof. In at least one example, the line cable 242 and/or the neutral cable 244 can be rated for the second, higher amperage. In at least one example, the terminal block 310 can be mounted within main body 306 the junction box 300 and/or each receptacle 242, 244 can be mounted through the door 308 of the junction box 300.

In at least one example, the first and second line receptacles 320 can be electrically coupled to the terminal block 310 through a first and second line wire 322, respectively. In at least one example, the first and second neutral receptacles 330 can be electrically coupled to the terminal block 310 through a first and second neutral wire 332, respectively. In at least one example, line wires 322 and/or the neutral wires 332 can be rated for the first, lower amperage. In at least one example, each line receptacle 320 and/or each neutral receptacle 330 also can be electrically coupled to the terminal block 310 through an individual switch 324, 334 and/or an individual fuse 334, 336 rated for the first amperage but not the second amperage. For example, the fuses 334, 336 can be sized to pass the first amperage, but blow when exposed to a higher amperage to protect the receptacles 320, 330, wires 322, 332, switches 324, 334, or any combination thereof.

In at least one example, the cabinet or rack 220 can include a test cable 260 configured to selectively electrically couple one of the outlets 118 of the rack power distribution unit 100 to one of the line receptacles 320 and one of the neutral receptacles 330. In at least one example, the cabinet or rack 220 can include a test cable 260 for each outlet 118 and/or set of line and neutral receptacles 320, 330. In at least one example, the test cable 260 can include a line wire 262, a neutral wire 264, a ground wire 266, or any combination thereof. In at least one example, the line wire 262, the neutral wire 264, and/or the ground wire 266 can be terminated in a line plug 272, a neutral plug 242, and a ground plug 276, respectively.

In at least one example, the junction box 300 also can include a first visual indicator 328 electrically coupled between the line receptacles 320 and/or a second visual indicator 338 electrically coupled between the neutral receptacles 330. In at least one example, the visual indicators 328, 338 can include a light emitting diode, a resistor, or any combination thereof. In at least one example, the first visual indicator 328 can be configured to indicate a voltage differential between the line receptacles 320. In at least one example, the second visual indicator 338 can be configured to indicate a voltage differential between the neutral receptacles 330. In at least one example, the junction box 300 also can include visual indicators 328, 338 electrically coupled between each pair of line receptacles 320 and/or each pair of neutral receptacles 330.

In at least one example, the junction box 300 also can include two or more ground receptacles 340. In at least one example, each ground receptacle 340 can be electrically coupled to the terminal block 310 through a ground wire 342. In at least one example, the ground wires 342 can be rated for the first, lower amperage. In at least one example, the terminal block 310 also can be electrically coupled to the load bank 240 by a ground cable 246. In at least one example, the ground cable 246 can be rated for the second, higher amperage.

In at least one example, the line plug 272, the neutral plug 242, and/or the ground plug 276 can be compatible with the line receptacles 320, the neutral receptacles 330, and/or the ground receptacles 340. In at least one example, the line plug 272, the neutral plug 242, and/or the ground plug 276 can be banana plugs, such as touchless banana plugs. In at least one example, line cable 242, the line receptacles 320, the line wire 322, the line wire 262, the line plug 272, or any combination thereof can be colored black. In at least one example, the neutral cable 244, the neutral receptacles 330, the neutral wire 332, the neutral wire 264, neutral plug 274, or any combination thereof can be colored red or white. In at least one example, the ground cable 246, the ground receptacles 340, the ground wire 342, the ground wire 266, ground plug 276, or any combination thereof can be colored green, with or without a yellow stripe.

In at least one example, the junction box 300 can include four line receptacles 320 and four neutral receptacles 330. In at least one example, the first amperage can be one-quarter (or about 25%) of the second amperage. For example, the wires 322, 332, 342 can be rated for 15 amps or less and the cables 242, 244, 246 can be rated for 40 amps or greater, such as 60 amps. In at least one example, the wires 322, 332, 342 can be 14 American Wire Gauge (AWG) or a similar size. In at least one example, the cables 242, 244, 246 can be 4, 6, or 8 AWG, or a similar size.

In at least one example, the line cable 242, the first line wire 322, and the second line wire 322 can be electrically coupled to one terminal 312 of the terminal block 310. In at least one example, the neutral cable 244, the first neutral wire 332, and the second neutral wire 332 can be electrically coupled to another, different terminal 314 of the terminal block 310. In at least one example, the ground cable 246, the first ground wire 342, and the second ground wire 342 can be electrically coupled to yet another, different terminal 316 of the terminal block 310.

In at least one example, a junction box 300 for facilitating testing of a rack power distribution unit 100 with a load bank 240 can include a terminal block 310 electrically coupled to the load bank 240 by a line cable 242 and a neutral cable 244, a first and a second line receptacle 320, a first and a second neutral receptacle 330, a first and a second test cable 260, or any combination thereof. In at least one example, the line cable 242 and/or the neutral cable 244 can be rated for a first amperage. In at least one example, the first and/or the second line receptacle 320 can be electrically coupled to the terminal block 310 through a first and/or a second line wire 322. In at least one example, the first and/or the second neutral receptacle 330 can be electrically coupled to the terminal block 310 through a first and/or a second neutral wire 332. In at least one example, the line wire(s) 322 and/or the neutral wire(s) 330 can be rated for a second amperage, with the second amperage being less than the first amperage. In at least one example, each test cable 260 can be configured to selectively electrically couple an outlet 118 of the rack power distribution unit 100 to one of the line receptacles 320 and one of the neutral receptacles 330. In at least one example, the terminal block 310 can be mounted within the junction box 300 and each receptacle 320, 330 can be mounted through a hinged door 308 of the junction box 300.

In at least one example, each line receptacle 332 and/or each neutral receptacle 330 are also electrically coupled to the terminal block 310 through an individual switch 324, 334 and/or individual fuse 326, 346 rated for the second, lower amperage but not the first, higher amperage. In at least one example, the line cable 242, the first line wire 322, and the second line wire 322 can be electrically coupled to a first terminal 312 of the terminal block 310. In at least one example, the neutral cable 244, the first neutral wire 332, and the second neutral wire 332 can be electrically coupled to a second, different terminal 314 of the terminal block 310.

In at least one example, the junction box 300 also can include a first visual indicator 328 electrically coupled between the line receptacles 320 and a second visual indicator 338 electrically coupled between the neutral receptacles 330. In at least one example, the first visual indicator 328 can be configured to indicate a voltage differential between the line receptacles 320. In at least one example, the second visual indicator 338 can be configured to indicate a voltage differential between the neutral receptacles 330.

In at least one example, the junction box 300 also can include first and second ground receptacles 340. In at least one example, each ground receptacle 340 can be electrically coupled to the terminal block 310 through a ground wire 342. In at least one example, the ground wire 342 can be rated for the second, lower amperage. In at least one example, the terminal block 310 can be electrically coupled to the load bank 240 by a ground cable 246, the ground cable 246 being rated for the first, higher amperage. In at least one example, the junction box 300 includes four line receptacles 320, four neutral receptacles 330, four ground receptacles 340. In at least one example, the first amperage can be four times the second amperage.

In at least one example, a junction box 300 for facilitating testing of a rack power distribution unit 100 with a load bank 240 can include a terminal block 310 electrically coupled to the load bank 240, four line receptacles 320, four neutral receptacles 330, four ground receptacles 340, four test cables 260, or any combination thereof. In at least one example, the terminal block 310 can be electrically coupled to the load bank 240 by a line cable 242, a neutral cable 244, a ground cable 246, or any combination thereof, with each cable 242, 244, 246 being rated for a first amperage, such as 60 amps.

In at least one example, each line receptacle 320 can be electrically coupled to the terminal block 310 through an individual line wire 322, an individual fuse 326, and an individual switch 324, with the line wires 322 and the fuses 326 being rated for a second, lower amperage, such as 15 amps. In at least one example, each neutral receptacle 330 can be electrically coupled to the terminal block 310 through an individual neutral wire 332, an individual fuse 336, and an individual switch 334, with the neutral wires 332 and the fuses 336 being rated for the second, lower amperage, such as 15 amps. In at least one example, each ground receptacle 340 can be electrically coupled to the terminal block through an individual ground wire 342, with the ground wires 340 being rated for the second, lower amperage, such as 15 amps.

In at least one example, each test cable 260 can be configured to selectively electrically couple an outlet 118 of the rack power distribution unit 100 to one of the line receptacles 320, one of the neutral receptacles 330, and one of the ground receptacles 340. In at least one example, the terminal block 310 and/or the fuses can be mounted within the junction box 310. In at least one example, each receptacle 320, 330, 340 and/or each switch 324, 334 can be mounted through a hinged door 308 of the junction box 300.

In at least one example, the junction box 300 also can include four line visual indicators 328. In at least one example, each line visual indicator 328 can be electrically coupled between two different ones of the line receptacles 320. In at least one example, each line visual indicator 328 can be configured to indicate a voltage differential between the respective line receptacles 320.

In at least one example, the junction box 300 also can include four line neutral indicators 338. In at least one example, each neutral visual indicator 338 can be electrically coupled between two different ones of the neutral receptacles 330. In at least one example, each neutral visual indicator 338 can be configured to indicate a voltage differential between the respective neutral receptacles 330.

In at least one example, the line cable 242 and the line wires 322 can be electrically coupled to a first terminal 312 of the terminal block 310. In at least one example, the neutral cable 244 and the neutral wires 332 can be electrically coupled to another terminal 314 of the terminal block 310. In at least one example, the ground cable 246 and the ground wires 342 can be electrically coupled to still another terminal 316 of the terminal block 310.

A technician can utilize the junction box 300 to test the outlets 118 of the rack power distribution unit(s) 100 mounted to the rack 220 utilizing the load bank 240, which can be a resistive bank. In use, the technician can turn off the rack power distribution unit(s) 100 and unplug anything plugged in the outlets 118 of the rack power distribution unit(s) 100. The technician can then plug a test cable 260 into the outlets 118 of the rack power distribution unit(s) 100. The technician can then plug the line plug 272 of the test cable 260 into one of the line receptacles 320, plug the neutral plug 274 of the test cable 260 into one of the neutral receptacles 330, and plug the ground plug 276 of the test cable 260 into one of the ground receptacles 340, repeating this for each outlet 118 the technician seeks to test. The technician can then view the visual indicators 328 and 338 to ensure that there is no phase or other voltage differential, and close the switches 324, 334. Finally, the technician can turn on the rack power distribution unit(s) 100 and test them using the load bank 240.

While examples of the disclosure have been described in the context of testing power distribution units for illustrative purposes, a person of ordinary skill in the art having the benefits of the present disclosure will understand that examples of the disclosure are not limited to testing of power distribution units in particular. For example, in at least one example, the devices, systems and methods of the disclosure can be configured for testing other equipment for computer equipment cabinets and datacenters, such as power generation units, power conditioning units and thermal conditioning units, whether separately or in combination with one another and/or one or more power distribution units.

In at least one example, a computer datacenter can include a computer equipment cabinet or rack, at least one rack power distribution unit mounted to the rack, a load bank mounted to the rack for testing the rack power distribution unit, a junction box electrically coupled to the load bank for facilitating testing power outlets of the rack power distribution unit, or any combination thereof. In at least one example, the rack power distribution unit can have one or more power outlets. In at least one example, each outlet can be rated at a first amperage and the load bank can be rated at a second amperage, and the second amperage can be greater than the first amperage.

In at least one example, the junction box can include a terminal block electrically coupled to the load bank by a line cable and/or a neutral cable, first and second line receptacles, first and second neutral receptacles, or any combination thereof. In at least one example, the line cable and/or the neutral cable can be rated for the second, higher amperage. In at least one example, the terminal block can be mounted within the junction box and/or each receptacle can be mounted through a hinged door of the junction box.

In at least one example, the first and second line receptacles can be electrically coupled to the terminal block through a first and second line wire, respectively. In at least one example, the first and second neutral receptacles can be electrically coupled to the terminal block through a first and second neutral wire, respectively. In at least one example, line wires and/or the neutral wires can be rated for the first, lower amperage. In at least one example, each line receptacle and/or each neutral receptacle also can be electrically coupled to the terminal block through an individual switch and/or an individual fuse rated for the first amperage but not the second amperage.

In at least one example, the cabinet can include a test cable configured to selectively electrically couple one of the outlets of the rack power distribution unit to one of the line receptacles and one of the neutral receptacles. In at least one example, the cabinet can include a test cable for each outlet and/or set of line and neutral receptacles.

In at least one example, the junction box also can include a first visual indicator electrically coupled between the line receptacles and/or a second visual indicator electrically coupled between the neutral receptacles. In at least one example, the first visual indicator can be configured to indicate a voltage differential between the line receptacles. In at least one example, the second visual indicator can be configured to indicate a voltage differential between the neutral receptacles. In at least one example, the junction box also can include visual indicators electrically coupled between each pair of line receptacles and/or each pair of neutral receptacles.

In at least one example, the junction box also can include two or more ground receptacles. In at least one example, each ground receptacle can be electrically coupled to the terminal block through a ground wire. In at least one example, the ground wires can be rated for the first, lower amperage. In at least one example, the terminal block can also be electrically coupled to the load bank by a ground cable. In at least one example, the ground cable can be rated for the second, higher amperage.

In at least one example, the junction box can include four line receptacles and four neutral receptacles. In at least one example, the first amperage can be one-quarter of the second amperage. For example, the wires can be rated for 15 amps or less and the cables can be rated for 40 amps or greater, such as 60 amps.

In at least one example, the line cable, the first line wire, and the second line wire can be electrically coupled to one terminal of the terminal block. In at least one example, the neutral cable, the first neutral wire, and the second neutral wire can be electrically coupled to another, different terminal of the terminal block.

In at least one example, a junction box for facilitating testing of a rack power distribution unit with a load bank can include a terminal block electrically coupled to the load bank by a line cable and a neutral cable, a first and a second line receptacle, a first and a second neutral receptacle, a first and a second test cable, or any combination thereof. In at least one example, the line cable and/or the neutral cable can be rated for a first amperage. In at least one example, the first and/or the second line receptacle can be electrically coupled to the terminal block through a first and/or a second line wire. In at least one example, the first and/or the second neutral receptacle can be electrically coupled to the terminal block through a first and/or a second neutral wire. In at least one example, the line wire(s) and/or the neutral wire(s) can be rated for a second amperage, with the second amperage being less than the first amperage. In at least one example, each test cable can be configured to selectively electrically couple an outlet of the rack power distribution unit to one of the line receptacles and one of the neutral receptacles. In at least one example, the terminal block can be mounted within the junction box and each receptacle can be mounted through a hinged door of the junction box.

In at least one example, each line receptacle and/or each neutral receptacle are also electrically coupled to the terminal block through an individual switch and/or individual fuse rated for the second, lower amperage but not the first, higher amperage. In at least one example, the line cable, the first line wire, and the second line wire can be electrically coupled to a first terminal of the terminal block. In at least one example, the neutral cable, the first neutral wire, and the second neutral wire can be electrically coupled to a second, different terminal of the terminal block.

In at least one example, the junction box also can include a first visual indicator electrically coupled between the line receptacles and a second visual indicator electrically coupled between the neutral receptacles. In at least one example, the first visual indicator can be configured to indicate a voltage differential between the line receptacles. In at least one example, the second visual indicator can be configured to indicate a voltage differential between the neutral receptacles.

In at least one example, the junction box also can include first and second ground receptacles. In at least one example, each ground receptacle can be electrically coupled to the terminal block through a ground wire. In at least one example, the ground wire can be rated for the second, lower amperage. In at least one example, the terminal block can be electrically coupled to the load bank by a ground cable, the ground cable being rated for the first, higher amperage. In at least one example, the junction box includes four line receptacles, four neutral receptacles, four ground receptacles. In at least one example, the first amperage can be four times the second amperage.

In at least one example, a junction box for facilitating testing of a rack power distribution unit with a load bank can include a terminal block electrically coupled to the load bank, four line receptacles, four neutral receptacles, four ground receptacles, four test cables, or any combination thereof. In at least one example, the terminal block can be electrically coupled to the load bank by a line cable and a neutral cable, with each cable being rated for a first amperage, such as 60 amps. In at least one example, each line receptacle can be electrically coupled to the terminal block through an individual line wire, an individual fuse, and an individual switch, with the line wires and the fuses being rated for a second, lower amperage, such as 15 amps. In at least one example, each neutral receptacle can be electrically coupled to the terminal block through an individual neutral wire, an individual fuse, and an individual switch, with the neutral wires and the fuses being rated for the second, lower amperage, such as 15 amps. In at least one example, each ground receptacle can be electrically coupled to the terminal block through an individual ground wire, with the ground wires being rated for the second, lower amperage, such as 15 amps. In at least one example, each test cable can be configured to selectively electrically couple an outlet of the rack power distribution unit to one of the line receptacles, one of the neutral receptacles, and one of the ground receptacles. In at least one example, the terminal block and/or the fuses can be mounted within the junction box. In at least one example, each receptacle and/or each switch can be mounted through a hinged door of the junction box.

In at least one example, the junction box also can include four line visual indicators. In at least one example, each line visual indicator can be electrically coupled between two different ones of the line receptacles. In at least one example, each line visual indicator can be configured to indicate a voltage differential between the respective line receptacles.

In at least one example, the junction box also can include four line neutral indicators. In at least one example, each neutral visual indicator can be electrically coupled between two different ones of the neutral receptacles. In at least one example, each neutral visual indicator can be configured to indicate a voltage differential between the respective neutral receptacles.

In at least one example, the line cable and the line wires can be electrically coupled to a first terminal of the terminal block. In at least one example, the neutral cable and the neutral wires can be electrically coupled to another terminal of the terminal block. In at least one example, the ground cable and the ground wires can be electrically coupled to still another terminal of the terminal block.

Other and further examples utilizing one or more aspects of the disclosure can be devised without departing from the scope of Applicants' disclosure. For example, the devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

Further examples are set out on the clauses below:
1. A computer datacenter, comprising:
   a computer equipment rack; at least one rack power distribution unit mounted to the rack, the at least one rack power distribution unit having a first power outlet and a second power outlet, each outlet being rated at a first amperage; a load bank mounted to the rack for testing the at least one rack power distribution unit,
   the load bank being rated at a second amperage, the second amperage being greater than the first amperage; and
   a junction box electrically coupled to the load bank for facilitating testing of the outlets of the at least one rack power distribution unit, the junction box including - a terminal block electrically coupled to the load bank by a line cable and a neutral cable, the line cable and the neutral cable being rated for the second amperage; a first line receptacle, the first line receptacle being electrically coupled to the terminal block through a first line wire, the first line wire being rated for the first amperage;
   a second line receptacle, the second line receptacle being electrically coupled to the terminal block through a second line wire, the second line wire being rated for the first amperage; a first neutral receptacle, the first neutral receptacle being electrically coupled to the terminal block through a first neutral wire, the first neutral wire being rated for the first amperage;
   a second neutral receptacle, the second neutral receptacle being electrically coupled to the terminal block through a second neutral wire, the second neutral wire being rated for the first amperage; at least two test cables, each test cable being configured to selectively electrically couple one of the outlets to one of the line receptacles and one of the neutral receptacles.
2. The datacenter of clause 1, wherein each line receptacle and each neutral receptacle are electrically coupled to the terminal block through an individual fuse rated for the first amperage but not the second amperage.
3. The datacenter of clause 1, wherein each line receptacle and each neutral receptacle are electrically coupled to the terminal block through an individual switch.
4. The datacenter of any one of clauses 1-3, wherein the junction box further includes a first visual indicator electrically coupled between the line receptacles and a second visual indicator electrically coupled between the neutral receptacles, the first visual indicator being configured to indicate a voltage differential between the line receptacles, and the second visual indicator being configured to indicate a voltage differential between the neutral receptacles.
5. The datacenter of any one of the preceding clauses, wherein the junction box further includes at least two ground receptacles, each ground receptacle being electrically coupled to the terminal block through a ground wire, the ground wire being rated for the first amperage, and wherein the terminal block is electrically coupled to the load bank by a ground cable, the ground cable being rated for the second amperage.
6. The datacenter of any one of the preceding clauses, wherein the junction box includes four line receptacles and four neutral receptacles and wherein the first amperage is one-quarter of the second amperage.
7. The datacenter of any one of the preceding clauses, wherein the terminal block is mounted within the junction box and each receptacle is mounted through a hinged door of the junction box.
8. The datacenter of any one of the preceding clauses, wherein the line cable, the first line wire, and the second line wire are electrically coupled to a first terminal of the terminal block and wherein the neutral cable, the first neutral wire, and the second neutral wire are electrically coupled to a second terminal of the terminal block.
9. A junction box for facilitating testing of a rack power distribution unit with a load bank, the junction box comprising: a terminal block electrically coupled to the load bank by a line cable and a neutral cable, the line cable and the neutral cable being rated for a first amperage; a first line receptacle, the first line receptacle being electrically coupled to the terminal block through a first line wire, the first line wire being rated for a second amperage, the second amperage being less than the first amperage; a second line receptacle, the second line receptacle being electrically coupled to the terminal block through a second line wire, the second line wire being rated for the second amperage; a first neutral receptacle, the first neutral receptacle being electrically coupled to the terminal block through a first neutral wire, the first neutral wire being rated for the second amperage; a second neutral receptacle, the second neutral receptacle being electrically coupled to the terminal block through a second neutral wire, the second neutral wire being rated for the second amperage; at least two test cables, each test cable being configured to selectively electrically couple an outlet of the rack power distribution unit to one of the line receptacles and one of the neutral receptacles.
10. The junction box of clause 9, wherein each line receptacle and each neutral receptacle are electrically coupled to the terminal block through an individual fuse rated for the second amperage but not the first amperage.
11. The junction box of clause 9, wherein each line receptacle and each neutral receptacle are electrically coupled to the terminal block through an individual switch.
12. The junction box of any one of clauses 9-11, wherein the junction box further includes a first visual indicator electrically coupled between the line receptacles and a second visual indicator electrically coupled between the neutral receptacles, the first visual indicator being configured to indicate a voltage differential between the line receptacles, and the second visual indicator being configured to indicate a voltage differential between the neutral receptacles.
13. The junction box of any one of clauses 9-12, wherein the junction box further includes at least two ground receptacles, each ground receptacle being electrically coupled to the terminal block through a ground wire, the ground wire being rated for the second amperage, and wherein the terminal block is electrically coupled to the load bank by a ground cable, the ground cable being rated for the first amperage.
14. The junction box of any one of clauses 9-13, wherein the junction box includes four line receptacles and four neutral receptacles and wherein the first amperage is four times the second amperage.
15. The junction box of any one of clauses 9-14, wherein the terminal block is mounted within the junction box and each receptacle is mounted through a hinged door of the junction box.
16. The junction box of any one of clauses 9-15, wherein the line cable, the first line wire, and the second line wire are electrically coupled to a first terminal of the terminal block and wherein the neutral cable, the first neutral wire, and the second neutral wire are electrically coupled to a second terminal of the terminal block.
17. A junction box for facilitating testing of a rack power distribution unit with a load bank, the junction box comprising: a terminal block electrically coupled to the load bank by a line cable and a neutral cable, the line cable and the neutral cable being rated for a first amperage; a first line receptacle, the first line receptacle being electrically coupled to the terminal block through a first line wire, a first fuse, and a first switch, the first line wire and the first fuse being rated for a second amperage but not the first amperage, the second amperage being one quarter the first amperage; a second line receptacle, the second line receptacle being electrically coupled to the terminal block through a second line wire, a second fuse, and a second switch, the second line wire and the second fuse being rated for the second amperage; a third line receptacle, the third line receptacle being electrically coupled to the terminal block through a third line wire, a third fuse, and a third switch, the third line wire and the third fuse being rated for the second amperage; a fourth line receptacle, the fourth line receptacle being electrically coupled to the terminal block through a fourth line wire, a fourth fuse, and a fourth switch, the fourth line wire and the fourth fuse being rated for the second amperage; a first neutral receptacle, the first neutral receptacle being electrically coupled to the terminal block through a first neutral wire, a fifth fuse, and a fifth switch, the first neutral wire and the fifth fuse being rated for the second amperage; a second neutral receptacle, the second neutral receptacle being electrically coupled to the terminal block through a second neutral wire, a sixth fuse, and a sixth switch, the second neutral wire and the sixth fuse being rated for the second amperage; a third neutral receptacle, the third neutral receptacle being electrically coupled to the terminal block through a third neutral wire, a seventh fuse, and a seventh switch, the third neutral wire and the seventh fuse being rated for the second amperage; a fourth neutral receptacle, the fourth neutral receptacle being electrically coupled to the terminal block through a fourth neutral wire, an eighth fuse, and an eighth switch, the fourth neutral wire and the eighth fuse being rated for the second amperage; a first ground receptacle, the first ground receptacle being electrically coupled to the terminal block through a first ground wire, the first ground wire being rated for the second amperage; a second ground receptacle, the second ground receptacle being electrically coupled to the terminal block through a second ground wire, the second ground wire being rated for the second amperage; a third ground receptacle, the third ground receptacle being electrically coupled to the terminal block through a third ground wire, the third ground wire being rated for the second amperage; a fourth ground receptacle, the fourth ground receptacle being electrically coupled to the terminal block through a fourth ground wire, the fourth ground wire being rated for the second amperage; at least four test cables, each test cable being configured to selectively electrically couple an outlet of the rack power distribution unit to one of the line receptacles, one of the neutral receptacles, and one of the ground receptacles.
18. The junction box of clause 17, wherein the junction box further includes four line visual indicators, each line visual indicator being electrically coupled between two different ones of the line receptacles, and each line visual indicator being configured to indicate a voltage differential between the respective line receptacles; and four line neutral indicators, each neutral visual indicator being electrically coupled between two different ones of the neutral receptacles, and each neutral visual indicator being configured to indicate a voltage differential between the respective neutral receptacles.
19. The junction box of clause 17 or 18, wherein the terminal block and the fuses are mounted within the junction box and each receptacle and each switch are mounted through a hinged door of the junction box.
20. The junction box of any one of clauses 17-19, wherein the line cable and the line wires are electrically coupled to a first terminal of the terminal block, wherein the neutral cable and the neutral wires are electrically coupled to a second terminal of the terminal block, and wherein the ground cable and the ground wires are electrically coupled to a third terminal of the terminal block.

The inventions have been described in the context of preferred and other examples and not every example of the inventions has been described. Obvious modifications and alterations to the described examples are available to those of ordinary skill in the art having the benefits of the present disclosure. The disclosed and undisclosed examples are not intended to limit or restrict the scope or applicability of the inventions conceived of by the Applicants, but rather, in conformity with the patent laws.

## Claims

1. A junction box for facilitating testing of a rack power distribution unit with a load bank, the junction box comprising:
a terminal block electrically coupled to the load bank by a line cable and a neutral cable, the line cable and the neutral cable being rated for a first amperage;
a first line receptacle, the first line receptacle being electrically coupled to the terminal block through a first line wire, the first line wire being rated for a second amperage, the second amperage being less than the first amperage;
a second line receptacle, the second line receptacle being electrically coupled to the terminal block through a second line wire, the second line wire being rated for the second amperage;
a first neutral receptacle, the first neutral receptacle being electrically coupled to the terminal block through a first neutral wire, the first neutral wire being rated for the second amperage;
a second neutral receptacle, the second neutral receptacle being electrically coupled to the terminal block through a second neutral wire, the second neutral wire being rated for the second amperage;
at least two test cables, each test cable being configured to selectively electrically couple an outlet of the rack power distribution unit to one of the line receptacles and one of the neutral receptacles.

2. The junction box of claim 1, wherein each line receptacle and each neutral receptacle are electrically coupled to the terminal block through an individual fuse rated for the second amperage but not the first amperage.

3. The junction box of claim 1 or 2, wherein each line receptacle and each neutral receptacle are electrically coupled to the terminal block through an individual switch.

4. The junction box of any one of claims 1-3, wherein the junction box further includes a first visual indicator electrically coupled between the line receptacles and a second visual indicator electrically coupled between the neutral receptacles, the first visual indicator being configured to indicate a voltage differential between the line receptacles, and the second visual indicator being configured to indicate a voltage differential between the neutral receptacles.

5. The junction box of any one of claims 1-4, wherein the junction box further includes at least two ground receptacles, each ground receptacle being electrically coupled to the terminal block through a ground wire, the ground wire being rated for the second amperage, and wherein the terminal block is electrically coupled to the load bank by a ground cable, the ground cable being rated for the first amperage; or optionally
wherein the junction box includes four line receptacles and four neutral receptacles and wherein the first amperage is four times the second amperage; or optionally
wherein the terminal block is mounted within the junction box and each receptacle is mounted through a hinged door of the junction box; or optionally
wherein the line cable, the first line wire, and the second line wire are electrically coupled to a first terminal of the terminal block and wherein the neutral cable, the first neutral wire, and the second neutral wire are electrically coupled to a second terminal of the terminal block.

6. The junction box as claimed in claim 1, wherein
the first line receptacle is further electrically coupled to the terminal block through a first fuse, and a first switch, the first line wire and the first fuse being rated for a second amperage but not the first amperage, the second amperage being one quarter the first amperage;
the second line receptacle is further electrically coupled to the terminal block through a second fuse, and a second switch, the second line wire and the second fuse being rated for the second amperage;
a third line receptacle, the third line receptacle being electrically coupled to the terminal block through a third line wire, a third fuse, and a third switch, the third line wire and the third fuse being rated for the second amperage;
a fourth line receptacle, the fourth line receptacle being electrically coupled to the terminal block through a fourth line wire, a fourth fuse, and a fourth switch, the fourth line wire and the fourth fuse being rated for the second amperage;
the first neutral receptacle is further electrically coupled to the terminal block through a fifth fuse, and a fifth switch, the first neutral wire and the fifth fuse being rated for the second amperage;
the second neutral receptacle is further electrically coupled to the terminal block through a sixth fuse, and a sixth switch, the second neutral wire and the sixth fuse being rated for the second amperage;
a third neutral receptacle, the third neutral receptacle being electrically coupled to the terminal block through a third neutral wire, a seventh fuse, and a seventh switch, the third neutral wire and the seventh fuse being rated for the second amperage;
a fourth neutral receptacle, the fourth neutral receptacle being electrically coupled to the terminal block through a fourth neutral wire, an eighth fuse, and an eighth switch, the fourth neutral wire and the eighth fuse being rated for the second amperage;
a first ground receptacle, the first ground receptacle being electrically coupled to the terminal block through a first ground wire, the first ground wire being rated for the second amperage;
a second ground receptacle, the second ground receptacle being electrically coupled to the terminal block through a second ground wire, the second ground wire being rated for the second amperage;
a third ground receptacle, the third ground receptacle being electrically coupled to the terminal block through a third ground wire, the third ground wire being rated for the second amperage;
a fourth ground receptacle, the fourth ground receptacle being electrically coupled to the terminal block through a fourth ground wire, the fourth ground wire being rated for the second amperage; and the junction box further including
at least two further test cables, each of the at least four test cable being configured to selectively electrically couple an outlet of the rack power distribution unit to one of the line receptacles, one of the neutral receptacles, and one of the ground receptacles.

7. The junction box of claim 6, wherein the junction box further includes
four line visual indicators, each line visual indicator being electrically coupled between two different ones of the line receptacles, and each line visual indicator being configured to indicate a voltage differential between the respective line receptacles; and
four line neutral indicators, each neutral visual indicator being electrically coupled between two different ones of the neutral receptacles, and each neutral visual indicator being configured to indicate a voltage differential between the respective neutral receptacles; or optionally
wherein the terminal block and the fuses are mounted within the junction box and each receptacle and each switch are mounted through a hinged door of the junction box; or optionally
wherein the line cable and the line wires are electrically coupled to a first terminal of the terminal block, wherein the neutral cable and the neutral wires are electrically coupled to a second terminal of the terminal block, and wherein the ground cable and the ground wires are electrically coupled to a third terminal of the terminal block.

8. A computer datacenter, comprising:
a computer equipment rack;
at least one rack power distribution unit mounted to the rack, the at least one rack power distribution unit having a first power outlet and a second power outlet, each outlet being rated at a first amperage;
a load bank mounted to the rack for testing the at least one rack power distribution unit, the load bank being rated at a second amperage, the second amperage being greater than the first amperage; and
a junction box electrically coupled to the load bank for facilitating testing of the outlets of the at least one rack power distribution unit, the junction box including -
a terminal block electrically coupled to the load bank by a line cable and a neutral cable, the line cable and the neutral cable being rated for the second amperage;
a first line receptacle, the first line receptacle being electrically coupled to the terminal block through a first line wire, the first line wire being rated for the first amperage;
a second line receptacle, the second line receptacle being electrically coupled to the terminal block through a second line wire, the second line wire being rated for the first amperage;
a first neutral receptacle, the first neutral receptacle being electrically coupled to the terminal block through a first neutral wire, the first neutral wire being rated for the first amperage;
a second neutral receptacle, the second neutral receptacle being electrically coupled to the terminal block through a second neutral wire, the second neutral wire being rated for the first amperage;
at least two test cables, each test cable being configured to selectively electrically couple one of the outlets to one of the line receptacles and one of the neutral receptacles.

9. The datacenter of claim 8, wherein each line receptacle and each neutral receptacle are electrically coupled to the terminal block through an individual fuse rated for the first amperage but not the second amperage.

10. The datacenter of claim 8, wherein each line receptacle and each neutral receptacle are electrically coupled to the terminal block through an individual switch.

11. The datacenter of any one of claims 8-10, wherein the junction box further includes a first visual indicator electrically coupled between the line receptacles and a second visual indicator electrically coupled between the neutral receptacles, the first visual indicator being configured to indicate a voltage differential between the line receptacles, and the second visual indicator being configured to indicate a voltage differential between the neutral receptacles.

12. The datacenter of any one of claims 8-11, wherein the junction box further includes at least two ground receptacles, each ground receptacle being electrically coupled to the terminal block through a ground wire, the ground wire being rated for the first amperage, and wherein the terminal block is electrically coupled to the load bank by a ground cable, the ground cable being rated for the second amperage.

13. The datacenter of any one of claims 8-12, wherein the junction box includes four line receptacles and four neutral receptacles and wherein the first amperage is one-quarter of the second amperage.

14. The datacenter of any one of claims 8-13, wherein the terminal block is mounted within the junction box and each receptacle is mounted through a hinged door of the junction box.

15. The datacenter of any one of claims 8-14, wherein the line cable, the first line wire, and the second line wire are electrically coupled to a first terminal of the terminal block and wherein the neutral cable, the first neutral wire, and the second neutral wire are electrically coupled to a second terminal of the terminal block.
